# FASCICULE DE BREVET EUROPEEN

(11) **EP 2 795 670 B1**
(45) Date de publication et mention de la délivrance du brevet: **09.03.2016**
(21) Numéro de dépôt: 12824902.6
(22) Date de dépôt: 19.12.2012
(51) Int. Cl.: H01L 21/683, H02N 13/00, H01L 21/67

(54) **SUPPORT COMPORTANT UN PORTE-SUBSTRAT ÉLECTROSTATIQUE**
TRÄGER MIT EINEM ELEKTROSTATISCHEN SUBSTRATHALTER
SUPPORT COMPRISING AN ELECTROSTATIC SUBSTRATE HOLDER

(30) Priorité: 21.12.2011 FR 1103981
(43) Date de publication de la demande: 29.10.2014
(73) Titulaire: Ion Beam Services, 13790 Peynier (FR)
(72) Inventeur: TORREGROSA Frank, F-13109 Simiane (FR); ROUX Laurent, F-13013 Marseille (FR)
(74) Mandataire: Renaud-Goud, Thierry
(86) Numéro de dépôt international: PCT/FR2012/000530
(87) Numéro de publication internationale: WO 2013/093238

(56) Documents cités:
- WO-A1-99/14796
- US-A1- 2005 042 881
- US-A1- 2006 016 561
- US-A1- 2010 078 129

## Description

La présente invention concerne un support comportant un porte-substrat électrostatique.

Le domaine de l'invention est celui du traitement de pièces dans une atmosphère sous faible pression, ces pièces montées sur un support étant soumises à un échauffement.

On pense en premier lieu à la microélectronique où les pièces traitées sont des substrats. Plus particulièrement, on vise l'implantation ionique qui permet l'introduction d'impuretés à l'intérieur du substrat, technique connue sous le nom de dopage. Le dopage permet de modifier certaines des propriétés du substrat qu'elles soient mécaniques, thermiques, électriques, hydrophobiques ou autres.

Pour réaliser cette implantation, on peut maintenant utiliser un implanteur ionique opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants. La polarisation est généralement pulsée.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par cm² et de la profondeur d'implantation.

L'implantation se fait dans une enceinte sous vide si bien que les échanges thermiques se faisant uniquement par rayonnement, il est difficile de maîtriser correctement la température du substrat.

Le document WO 99/14796 A présente un support de substrat utilisable dans une chambre à plasma, le support étant électriquement couplé à un anneau électriquement conducteur. Ledit anneau permet l'obtention d'un volume de plasma - traitant un substrat supporté par ledit support - plus uniforme.

Le document US 7,126,808 B2 propose un appareil muni d'un support équipé avec un porte-substrat électrostatique qui comporte une chambre de réfrigération. Cet appareil comprend un porte-substrat muni d'une pluralité de canaux qui s'étendent entre sa face supérieure et sa face inférieure. Une pointe de levage figure dans chaque canal. Les pointes de levage permettent en premier lieu de soulever légèrement le substrat au-dessus du porte-substrat pour assurer le serrage électrostatique. L'espace compris entre le substrat et le porte-substrat est empli d'un gaz réfrigérant.

Le substrat est maintenu uniquement à la périphérie du porte-substrat, ce qui n'est pas satisfaisant sur un plan mécanique.

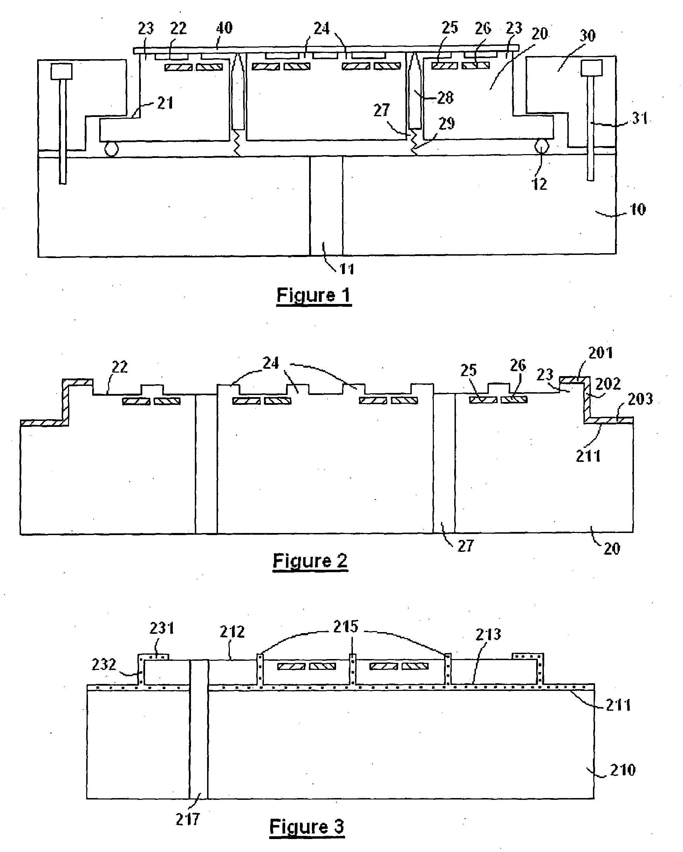

Un autre support connu est représenté sur la figure 1. Ici, le support comprend essentiellement trois parties :
- une table polarisée 10,
- un porte-substrat 20, et
- une bride de serrage 30.

La table 10 qui est polarisée à la haute tension (continue ou pulsée) se présente comme un plateau conducteur muni d'un conduit 11 qui débouche sur ses deux faces. La fonction de ce conduit 11 est détaillée plus loin.

Le porte-substrat isolant 20 repose sur la table 10 par l'intermédiaire d'un joint 12 agencé à la périphérie de la face inférieure de ce porte-substrat. Il se présente comme un cylindre qui s'appuie sur sa face supérieure, ce cylindre étant muni d'un épaulement 21 qui fait saillie à sa base.

La bride de serrage 30 permet de serrer le porte-substrat 20 sur la table 10 en prenant appui sur l'épaulement 21, ceci au moyen d'une pluralité de vis 31.

La face supérieure 22 du porte-substrat 20 présente un anneau 23 à sa périphérie et elle présente aussi une pluralité de plots 24 répartis à l'intérieur de cet anneau. L'épaisseur de l'anneau 23 et celle des plots 24 sont identiques et elle vaut typiquement 10 à 15 µm. Les sommets de l'anneau 23 et des plots 24 définissent ainsi un plan d'appui sur lequel repose le substrat 40.

Un premier type d'électrodes est utilisé pour le serrage électrostatique du substrat. Ces électrodes sont réparties par paires. Elles sont disposées dans un plan parallèle à la face supérieure 22, plan qui est très voisin de cette face supérieure. Elles sont réalisées par tout moyen connu de l'homme de l'art, par exemple en recourant à la technologie dite « couche épaisse ».

La paire qui se trouve à droite sur la figure comporte une électrode positive 25 ou anode et une électrode négative 26 ou cathode. Le principe consiste à réaliser un double condensateur :
- un condensateur anode-substrat
- un condensateur substrat-cathode.

Par ailleurs, il convient d'assurer le contact électrique entre le substrat 40 et la table polarisée 10 et cela se fait au moyen d'un deuxième type d'électrodes.

A cet effet, plusieurs canaux traversent le porte-substrat 20 de part en part. Le canal 27 qui est à droite sur la figure reçoit une pointe 28 montée sur un ressort 29 qui prend appui sur la table 10 et qui presse donc la pointe 28 contre le substrat 40. Le couple pointe-ressort constitue une électrode du deuxième type et on prévoit un tel couple dans chaque canal.

Le conduit 11 ménagé dans la table sert à emplir d'hélium le premier espace qui figure entre la face inférieure du porte-substrat 20 et cette table.

Le deuxième espace compris entre la face supérieure 22 du porte-substrat 20 et le substrat 40 est également comblé d'hélium du fait des canaux. On peut même prévoir une ouverture supplémentaire (non représentée) qui traverse le porte-substrat pour faire communiquer le premier et le deuxième espace.

Les moyens propres à la manipulation du substrat sont omis car ils sont connus de l'homme du métier.

Lors de l'implantation, le courant d'implantation est drainé par les électrodes du deuxième type. La surface de contact des pointes 28 est petite si bien que la densité de courant est importante. Il peut s'ensuivre une fusion des pointes et une contamination de la face arrière du substrat, ceci plus particulièrement si la tension de polarisation est pulsée.

La présente invention a ainsi pour objet d'augmenter la surface par laquelle transite le courant d'implantation.

Selon l'invention, un support comporte :
- une table polarisée électriquement conductrice,
- un porte-substrat isolant électrostatique prenant la forme d'un cylindre pourvu d'un épaulement, la face inférieure de ce porte-substrat venant en regard de la table polarisée et sa face supérieure présentant un plan d'appui prévu pour recevoir un substrat,
- une bride de serrage électriquement conductrice pour brider l'épaulement sur la table polarisée ;
de plus, ce support comprend au moins un élément électriquement conducteur pour raccorder le plan d'appui à l'épaulement.

Suivant un premier mode de réalisation, l'élément électriquement conducteur comporte :
- un premier ruban agencé à la périphérie de la face supérieure,
- un deuxième ruban qui s'étend sur le cylindre entre le premier ruban et l'épaulement,
- un troisième ruban au contact du deuxième ruban agencé sur l'épaulement.

Avantageusement, le support comporte de plus une pluralité d'électrodes qui traversent le porte-substrat et qui assurent un contact électrique entre la table polarisée et le plan d'appui.

Suivant un deuxième mode de réalisation, l'élément électriquement conducteur comprend :
- un plan de contact électriquement conducteur agencé dans le porte-substrat au niveau de l'épaulement,
- une pluralité d'électrodes connectées au plan de contact qui font saillie sur la face supérieure pour définir le plan d'appui.

De préférence, le support comportant de plus un ruban agencé à la périphérie de la face supérieure sous le plan d'appui, le porte-substrat comprend au moins un orifice débouchant à sa face supérieure et à sa face inférieure.

Selon une caractéristique additionnelle de l'invention, le support comporte de plus une couche électriquement conductrice interposée entre la face supérieure et la table polarisée.

Avantageusement, les électrodes se présentent comme des trous métallisés.

Eventuellement, le support comporte de plus un joint à la périphérie de la face inférieure au contact de la table polarisée.

Alternativement, le support comporte de plus une couche thermiquement conductrice interposée entre la face inférieure et la table polarisée.

La présente invention apparaîtra maintenant avec plus de détails dans le cadre de la description qui suit d'exemples de réalisation donnés à titre illustratif en se référant aux figures jointes parmi lesquelles :
- la figure 1 représente un schéma en coupe d'un support connu,
- la figure 2 représente un schéma en coupe d'un premier mode de réalisation d'un support selon l'invention, et
- la figure 3 représente un schéma en coupe d'un deuxième mode de réalisation d'un support selon l'invention.

Les éléments présents sur plusieurs figures sont affectés d'une seule et même référence.

L'invention se propose donc d'établir un contact électrique entre le plan d'appui du porte-substrat et l'épaulement de ce porte-substrat.

En référence à la figure 2, suivant un premier mode de réalisation, on reprend le porte-substrat 20 décrit ci-dessus.

Un premier ruban métallique 201 est déposé sur l'anneau 23 qui figure à la périphérie de la face supérieure 22 du porte-substrat 20. Il est réalisé par exemple suivant la technologie dite « couches minces » avec un matériau tel que titane, nitrure de titane, platine, tungstène, carbure de tungstène. Il faut en tout état de cause un matériau conducteur qui soit si possible réfractaire.

L'épaisseur du ruban doit être suffisante pour présenter une résistance électrique acceptable mais elle ne doit pas être trop élevée de sorte que le substrat repose bien sur les plots 24. Une valeur convenable pour cette épaisseur est comprise entre 1 µm et 2 µm.

Un deuxième ruban métallique 202 est déposé sur la paroi cylindrique du porte-substrat 20 entre le premier ruban 201 et l'épaulement 21.

Finalement, un troisième ruban métallique 203 est déposé sur la face de l'épaulement 21 qui vient en regard de la bride de serrage 30.

Les trois rubans ainsi juxtaposés assurent la continuité électrique depuis la face d'appui jusqu'à la bride de serrage qui est elle-même conductrice.

La surface de contact électrique sur le substrat est ainsi fortement augmentée permettant un meilleur drainage des charges dues au courant d'implantation. On peut même envisager de supprimer les électrodes du deuxième type qui assuraient le contact entre la face arrière du substrat 40 et la table polarisée 10.

Si l'on supprime ces électrodes, il faut toutefois conserver un canal 27 au moins pour acheminer l'hélium du premier espace qui figure entre la face inférieure du porte-substrat 20 et la table 10 au deuxième espace compris entre la face supérieure 22 du porte-substrat 20 et le substrat 40.

On peut donc supprimer ces électrodes du deuxième type, les conserver, ou même en changer la configuration.

En effet, en conservant un canal 27 et en le métallisant, on peut réaliser ce que l'homme du métier appelle un trou métallisé. Ce trou métallisé assure un contact électrique entre le plan d'appui et la face inférieure du porte-substrat 20.

En référence à la figure 3, suivant un deuxième mode de réalisation, le porte-substrat 210 est identique au précédent si ce n'est que sa face supérieure 212 est plane car on a supprimé l'anneau et les plots.

Maintenant, le porte-substrat 210 comporte un plan de contact 213 électriquement conducteur, perpendiculaire à l'axe du cylindre et qui recouvre l'épaulement 211.

Une pluralité d'électrodes 215 d'un troisième type sont agencées perpendiculairement au plan de contact et font saillie sur la face supérieure 212 du porte-substrat 210. Ces électrodes sont en contact avec le plan de contact et elles dépassent donc légèrement de la face supérieure 212, de l'ordre de 10 µm à 15 µm. Elles consistent, à titre d'exemple, en des trous métallisés.

On conserve le premier ruban métallique 231 qui est déposé à la périphérie de la face supérieure 212 du porte-substrat 210. Ce premier ruban 231 vient sensiblement au même niveau que les électrodes 215 du troisième type. Ce premier ruban contribue à étancher l'assemblage substrat / porte-substrat pour limiter les fuites d'hélium à la périphérie du substrat.

De préférence, on conserve également le deuxième ruban 232 métallique qui raccorde le premier ruban 231 au plan de contact 213, ceci toujours dans le souci d'améliorer le drainage des charges dues au courant d'implantation.

On prévoit toujours un orifice 217 qui traverse le porte-substrat de part en part pour faire communiquer le premier espace qui figure entre la face inférieure du porte-substrat 210 et la table 10, et le deuxième espace compris entre la face supérieure 212 du porte-substrat 210 et le substrat 40.

Le porte-substrat 210 tel que décrit ci-dessus est aisément réalisable en recourant à la technologie « couches épaisses ».

Pour les électrodes 215 du troisième type, on peut prévoir des inserts métalliques en lieu et place des trous métallisés.

En revenant à la figure 1, il convient d'obtenir un échange thermique le meilleur possible entre le porte-substrat 20 et la table 10.

Pour ce faire, une première solution consiste à emplir d'Hélium l'espace qui figure entre ces deux éléments au moyen du conduit 11.

Une autre solution consiste à interposer entre ces deux éléments une couche thermiquement conductrice telle que de la colle, de la graisse ou une feuille d'indium. Selon les cas, cette couche peut avantageusement être également électriquement conductrice. Dans ce cas, il faut cependant toujours ménager un circuit pour que l'hélium puisse atteindre l'espace compris entre le substrat 40 et le porte-substrat 20.

Jusqu'à présent, seul l'hélium a été mentionné comme gaz caloporteur L'invention s'applique également si on emploie un autre gaz tel que l'hydrogène par exemple.

Les exemples de réalisation de l'invention présentés ci-dessus ont été choisis eu égard à leurs caractères concrets. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention, la présente invention étant définie par le présent jeu de revendications.

## Revendications

1. Support comportant :
- une table (10) polarisée électriquement conductrice,
- un porte-substrat (20) isolant électrostatique prenant la forme d'un cylindre pourvu d'un épaulement (21), la face inférieure de ce porte-substrat (20) venant en regard de ladite table (10) polarisée et sa face supérieure (22, 212) présentant un plan d'appui prévu pour recevoir un substrat (40),
- une bride de serrage (30) électriquement conductrice pour brider ledit épaulement (21) sur ladite table (10) polarisée,
**caractérisé en ce qu'**il comprend au moins un élément (201-202-203, 213-215) électriquement conducteur pour raccorder ledit plan d'appui audit épaulement (21).

2. Support selon la revendication 1, **caractérisé en ce que** ledit élément électriquement conducteur comporte :
- un premier ruban (201) agencé à la périphérie de ladite face supérieure (22),
- un deuxième ruban (202) qui s'étend sur ledit cylindre entre ledit premier ruban (201) et ledit épaulement (21),
- un troisième ruban (203) au contact dudit deuxième ruban (202) agencé sur ledit épaulement (21).

3. Support selon la revendication 2, **caractérisé en ce qu'**il comporte de plus une pluralité d'électrodes (28-29) qui traversent ledit porte-substrat (20) et qui assurent un contact électrique entre ladite table (10) polarisée et ledit plan d'appui.

4. Support selon la revendication 1, **caractérisé en ce que** ledit élément électriquement conducteur comprend :
- un plan de contact (213) électriquement conducteur agencé dans ledit porte-substrat (210) au niveau dudit épaulement (211),
- une pluralité d'électrodes (215) connectées audit plan de contact (213) qui font saillie sur ladite face supérieure (212) pour définir ledit plan d'appui.

5. Support selon la revendication 4 **caractérisé en ce que**, comportant de plus un ruban (231) agencé à la périphérie de ladite face supérieure (212) sous ledit plan d'appui, ledit porte-substrat (210) comprend au moins un orifice (217) débouchant à sa face supérieure et à sa face inférieure.

6. Support selon la revendication 3, **caractérisé en ce qu'**il comporte de plus une couche électriquement conductrice interposée entre ladite face supérieure (22, 212) et ladite table (10) polarisée.

7. Support selon l'une quelconque des revendications 3 à 5, **caractérisé en ce que** lesdites électrodes (215) se présentent comme des trous métallisés.

8. Support selon l'une quelconque des revendications 1 à 5, **caractérisé en ce qu'**il comporte de plus un joint (12) à la périphérie de ladite face inférieure au contact de ladite table (10) polarisée.

9. Support selon l'une quelconque des revendications 1 à 5, **caractérisé en ce qu'**il comporte de plus une couche thermiquement conductrice interposée entre ladite face inférieure et ladite table (10) polarisée.

## Patentansprüche

1. Träger, der aufweist:
- einen elektrisch leitenden, polarisierten Tisch (1),
einen elektrostatischen isolierenden Substrathalter (20), der die Form eines mit einer Schulter (21) versehenen Zylinders annimmt, wobei die Unterseite dieses Substrathalters (20) dem polarisierten Tisch (10) gegenüberliegt und seine Oberseite (22, 212) eine Auflageebene aufweist, die zur Aufnahme eines Substrats (40) vorgesehen ist,
- einen elektrisch leitenden Klemmflansch (30), um die Schulter (21) an den polarisierten Tisch (10) anzuflanschen,
dadurch gekennzeichet, dass er mindestens ein elektrisch leitendes Element (201-202-203, 213-215) enthält, um die Auflageebene an die Schulter (21) anzuschließen.

2. Träger nach Anspruch 1, dadurch gekenntzeichnet, dass das elektrisch leitende Element aufweist:
- einen ersten Streifen (201), der am Rand der Oberseite (22) angeordnet ist,
- einen zweiten Streifen (202), der sich auf dem Zylinder zwischen dem ersten Streifen (201) und der Schulter (21) erstreckt,
- einen dritten Streifen (203) in Kontakt mit dem zweiten Streifen (202), der auf der Schulter (21) angeordnet ist.

3. Träger nach Anspruch 2, **dadurch gekennzeichnet, dass** er außerdem eine Vielzahl von Elektroden (28-29) aufweist, die den Substrathalter (20) durchqueren und einen elektrischen Kontakt zwischen dem polarisierten Tisch (10) und der Auflageebene gewährleisten.

4. Träger nach Anspruch 1, **dadurch gekennzeichnet, dass** das elektrisch leitende Element enthalt:
- eine elektrisch leitende Kontaktebene (213), die im Substrathalter (210) im Bereich der Schulter (211) angeordnet ist,
- eine Vielzahl von mit der Kontaktebene (213) verbundenen Elektroden (215), die an der Oberseite (212) vorstehen, um die Auflageebene zu definierten.

5. Träger nach Anspruch 4, **dadurch gekennzeichnet, dass**, wenn er außerdem einen Streifen (231) aufweist, der am Rand der Oberseite (212) unter der Auflageebene angeordnet ist, der Substrathalter (210) mindestens eine Öffnung (217) enthält, die an seiner Oberseite und an seiner Unterseite mündet.

6. Träger nach Anspruch 3, **dadurch gekennzeichnet, dass** er außerdem seine elektrisch leitende Schicht aufweiset, die zwischen die Oberseite (22, 212) und den polarisierten Tisch (10) eingefügt ist.

7. Träger nach einem der Ansprüche 3 bis 5, **dadurch gekennzeichnet, dass** die Elektroden (215) als metallbeschichtete Löcher vorlieben.

8. Träger nach einem der Ansprüche 1 bis 5, **dadurch gekennzeichnet, dass** er außerdem eine Dichtung (12) am Rand der Unterseite in Kontakt mit dem polarisierten Tisch (10) aufweiset.

9. Träger nach einem der Ansprüche 1 bis 5, **dadurch gekennzeichnet, dass** er außerdem eine wärmeleitende Schicht aufweist, die zwischen die Oberseite und den polarisierten Tisch (10) eingefügt ist.

## Claims

1. A support comprising:
• an electrically conductive biased table (10);
• an insulating electrostatic substrate carrier (20) in the form of a cylinder having a shoulder (211), the bottom face of the substrate carrier (20) facing said biased table (10) and its top face (22, 212) presenting a bearing plane designed to receive a substrate (40); and
• an electrically conductive clamping collar (30) for clamping said shoulder (211) against said biased table (10);
the support being **characterized in that** it includes at least one electrically conductive element (201-202-203, 213-215) for connecting said bearing plane to said shoulder (211).

2. A support according to claim 1, **characterized in that** said electrically conductive element comprises:
• a first strip (201) arranged at the periphery of said top face (22);
• a second strip (202) that extends over said cylinder between said first strip (201) and said shoulder (211); and
• a third strip (203) in contact with said second strip (202) and arranged on said shoulder (211).

3. A support according to claim 2, **characterized in that** it also includes a plurality of electrodes (28-29) that pass through said substrate carrier (20) and that provide electrical contact between said biased table (10) and said bearing plane.

4. A support according to claim 1, **characterized in that** said electrically conductive element comprises:
• an electrically conductive contact plane (213) arranged in said substrate carrier (210) at said shoulder (211); and
• a plurality of electrodes (215) connected to said contact plane (213) that project from said top face (212) to define said bearing plane.

5. A support according to claim 4, **characterized in that** it further includes a strip (231) arranged at the periphery of said top face (212) under said bearing plane, and said substrate carrier (210) includes at least one orifice (217) opening out in its top face and its bottom face.

6. A support according to claim 3, **characterized in that** it further includes an electrically conductive layer interposed between said top face (22, 212) and said biased table (10).

7. A support according to any one of claims 3 to 5, **characterized in that** said electrodes (215) are in the form of plated-through holes.

8. A support according to any one of claims 1 to 5, **characterized in that** it further includes a gasket (12) at the periphery of said bottom face in contact with said biased table (10).

9. A support according to any one of claims 1 to 5, **characterized in that** it further includes a thermally conductive layer interposed between said bottom face and said biased table (10).
